# EUROPÄISCHE PATENTANMELDUNG

(11) **EP 0 865 102 A2**
(43) Veröffentlichungstag der Anmeldung: **16.09.1998**
(21) Anmeldenummer: 97104462.3
(22) Anmeldetag: 15.03.1997
(51) Int. Cl.: H01R 4/02

(54) **Lötverbindung für elektrische Verbindungen**

(30) Priorität: 15.03.1997 DE 19621211
(71) Anmelder: Mannesmann VDO AG, 60326 Frankfurt (DE)
(72) Erfinder: König, Eberhard, 61138 Niederdorfelden (DE)
(74) Vertreter: Klein, Thomas, Dipl.-Ing.

(57) **Zusammenfassung**

Die Lötverbindung mit einem Kontaktstift (2) einem Lötauge (3) und einer Leitung (4), wobei das Leitungsende (5) innerhalb der Außenbegrenzung (6) des Lötauges (3) liegt, weist die Besonderheit auf, daß das Lötauge (3) im Bereich des Leitungsendes (5) eine Ausnehmung (7) aufweist, wodurch ein das Leitungsende (5) allseits umgebender Spalt (8) vorliegt, der beim Lötvorgang durch Lötmaterial geschlossen wird.

## Beschreibung

Die Erfindung bezieht sich auf eine Lötverbindung für elektrische Verbindungen, umfassend einen Kontaktstift, ein den Kontaktstift umgebendes Lötauge und mindestens eine Leitung, deren Ende innerhalb der Außenbegrenzung des Lötauges liegt.

Bei Lötverbindungen dieser Art, die Von Hand oder von Robotern durchgeführt werden, ist es nicht immer auszuschließen, daß eine Lötverbindung entweder aufgrund eines technischen Fehlers bei der Roboterverlötung, oder weil sie vergessen wurde, nicht ausgeführt ist. Bei der Endprüfung solcher Lötverbindungen kann ein solcher Fehler nicht immer mit Sicherheit erkannt werden, weil der Kontaktstift an dem Lötauge anliegen kann und somit kontaktiert ist, wodurch eine elektrische Verbindung angezeigt wird. Dieser Fehler tritt jedoch bei der Benutzung eines Gerätes mit einer derartigen fehlerhaften Lötstelle später auf und verursacht somit eine aufwendige Reparatur. Bei der serienmäßigen Herstellung großer Anzahlen von Lötverbindungen ist es zwar üblich, den Lötvorgang bzw. die Lötverbindung durch eine Kamera zu überwachen, was aber einen erheblichen Aufwand darstellt.

Aufgabe der Erfindung ist es, eine Lötverbindung so auszugestalten, daß ein nicht durchgeführter Lötvorgang bei der elektrischen Kontrolle mit Sicherheit wahrgenommen wird.

Diese Aufgabe wird ausgehend von einer Lötverbindung der eingangs angegebenen Art erfindungsgemäß dadurch gelöst, daß das Lötauge im Bereich der Leitung eine Ausnehmung mit einem die zu verbindende Leitung allseits umgebenden Spalt aufweist, der beim Verlöten des Kontaktstiftes mit dem Lötauge mit Lötmaterial schließbar ist.

Durch diese erfindungsgemäße Ausgestaltung wird erreicht, daß bei einem ausgelassenen Lötvorgang auch bei Berührung des Kontaktstiftes mit dem Lötauge keine elektrische Verbindung vorliegt, weil die zu verbindende Leitung durch den Spalt von dem Lötauge getrennt ist und eine elektrische Verbindung nur dann entstehen kann, wenn der Lötvorgang ausgeführt ist.

Da insbesondere bei Handlötungen der Lötpunkt unterschiedlich groß in seiner Flächenausdehnung ausfallen kann, ist es vorteilhaft, wenn in weiterer Ausgestaltung der Erfindung das Lötauge im Bereich des Leitungsendes erweitert ist. Hierdurch werden größere Grenzflächen zwischen dem Lötauge und dem Leitungsende geschaffen, wodurch die Sicherheit beim Lötvorgang erhöht wird. Es ist aber auch möglich zur Schaffung größerer Grenzbereiche das Leiterende zu erweitern.

Die Erfindung wird nachfolgend anhand mehrerer in der Zeichnung dargestellter Ausführungsbeispiele näher erläutert. In der Zeichnung zeigen:
- **Figur 1:**: Eine Grundform einer Lötverbindung; und
- **Figuren 2 bis 4:**: Weitere Ausführungsvarianten von Lötverbindungen.

Auf einer ausschnittsweise dargestellten Leiterplatte 1, die von einem Kontaktstift 2 durchsetzt ist, ist ein Lötauge 3 und eine Leitung 4 aufkaschiert. Im Bereich des mit 5 bezeichneten Leitungsendes, welches innerhalb der Außenbegrenzung 6 des Lötauges 3 liegt, weist das Lötauge 3 eine Ausnehmung 7 auf, die so groß bemessen ist, daß zwischen dem Lötauge 3 und dem Leitungsende 5 ein allseits das Leitungsende 5 umgebender Spalt 8 verbleibt.

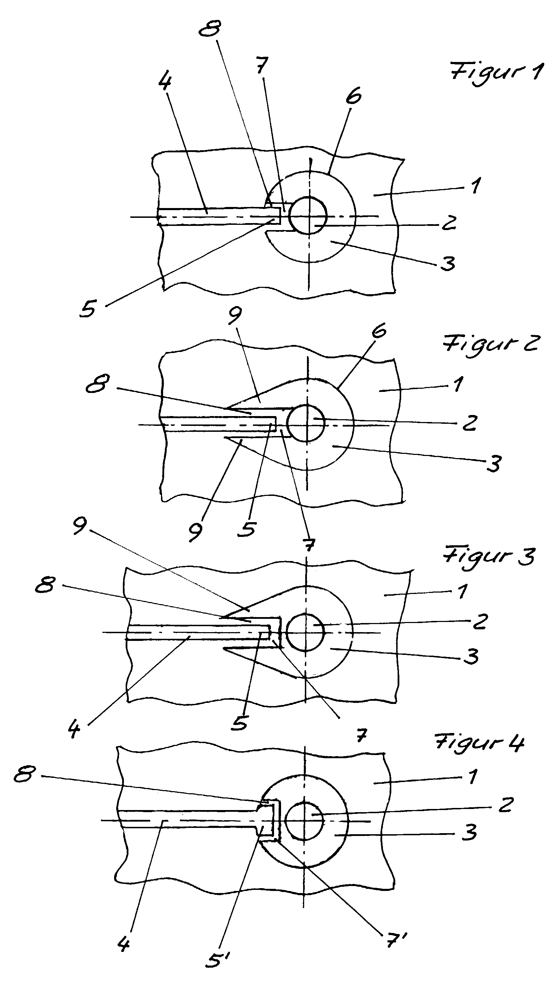

Die in den Figuren 2 bis 4 dargestellten Varianten beruhen auf dem gleichen Grundprinzip. Aus diesem Grunde sind übereinstimmende Teile mit den gleichen Bezugszahlen versehen.

Die Ausführungsbeispiele nach den Figuren 2 und 3 unterscheiden sich grundsätzlich von demjenigen nach Figur 1 dadurch, daß die Außenbegrenzung 6 des Lötauges 3 im Bereich des Leitungsendes 5 durch Ansätze 9 erweitert ist, so daß ein vergrößerter Grenzbereich zwischen dem Leitungsende 5 und dem Lötauge 3 gebildet ist. Der Unterschied zwischen dem Beispiel nach Figur 2 und demjenigen nach Figur 3 besteht darin, daß die Ausnehmung 7 bei dem Beispiel nach Figur 2 bis zu dem Kontaktstift 2 ausgeführt ist, während bei Ausführungsbeispiel nach Figur 3 die Ausnehmung 7 nicht bis an den Kontaktstift heranreicht, sondern dieser an seinem gesamten Umfang vom Lötauge 3 umgeben ist.

Bei der Ausführungsvariante nach Figur 4 entspricht das Lötauge 3 im wesentlichen demjenigen nach Figur 1. Hier ist das Leitungsende 5' erweitert, wodurch eine gegenüber Figur 1 größere Ausnehmung 7' erforderlich ist, um den notwendigen Spalt 8 zwischen Lötauge und Leitung 4 zu gewährleisten.

## Patentansprüche

1. Lötverbindung für elektrische Verbindungen, umfassend einen Kontaktstift, ein den Kontaktstift umgebendes Lötauge und mindestens eine Leitung, deren Ende innerhalb der Außenbegrenzung des Lötauges liegt, **dadurch gekennzeichnet,** daß das Lötauge (3) im Bereich der Leitung eine Ausnehmung (7) mit einem die zu verbindende Leitung (4) allseits umgebenden Spalt (8) aufweist, der beim Verlöten des Kontaktstiftes (2) mit dem Lötauge (3) mit Lötmaterial schließbar ist.

2. Lötverbindung nach Anspruch 1, **dadurch gekennzeichnet,** daß das Lötauge (3) im Bereich des Leitungsendes (5) erweitert (9) ist.

3. Lötverbindung nach Anspruch 1 oder 2, **dadurch gekennzeichnet,** daß das Leitungsende (5') erweitert ist.
